# EUROPÄISCHE PATENTSCHRIFT

(11) **EP 0 748 507 B1**
(45) Veröffentlichungstag und Bekanntmachung des Hinweises auf die Patenterteilung: **16.06.1999**
(21) Anmeldenummer: 95907559.9
(22) Anmeldetag: 07.02.1995
(51) Int. Cl.: H01B 1/20, C09J 9/02, C08K 9/04

(54) **ANISOTROP LEITENDER KLEBER**
ANISOTROPICALLY CONDUCTING ADHESIVE
ADHESIF A CONDUCTIBILITE ANISOTROPE

(30) Priorität: 28.02.1994 DE 4406418
(43) Veröffentlichungstag der Anmeldung: 18.12.1996
(73) Patentinhaber: ROBERT BOSCH GMBH, 70442 Stuttgart (DE)
(72) Erfinder: GRUENWALD, Werner, D-70839 Gerlingen (DE); HAUG, Ralf, D-71229 Leonberg (DE); HAUSCHILD, Frank-Dieter, D-31139 Hildesheim (DE); SEYFFERT, Martin, D-31139 Hildesheim (DE); GUENSTER, Holger, D-31137 Hildesheim (DE)
(86) Internationale Anmeldenummer: DE9500151
(87) Internationale Veröffentlichungsnummer: WO9523416

(56) Entgegenhaltungen:
- EP-A- 0 265 212
- FR-A- 2 282 148
- CHEMICAL ABSTRACTS, vol. 117, no. 16, 19.Oktober 1992 Columbus, Ohio, US; abstract no. 152125, & JP,A,04 050 256 (HEISEI) 19.Februar 1992

## Beschreibung

Die Erfindung betrifft einen anisotrop leitenden Kleber nach dem Oberbegriff des Anspruchs 1.

### Stand der Technik

Anisotrop leitende Kleber sind bekannt. Diese weisen in einem Basismaterial, beispielsweise in einem thermoplastischen Material, feinverteilte leitfähige Teilchen auf. Die leitfähigen Teilchen werden dabei als körnchenförmiges Pulver in dem Basismaterial dispergiert. Die anisotrop leitenden Kleber liegen beispielsweise in Folienform vor und sind geeignet, zwei Kontakte, beispielsweise zwei Leiterbahnen, elektrisch leitend miteinander zu verkleben. Die Leiterbahnen werden unter Druck- und Temperatureinwirkung auf die gegenüberliegenden Seiten des Leitklebers gepreßt, so daß sich das Basismaterial verformt und die in diesem verteilten leitfähigen Teilchen eine elektrisch leitende Verbindung zwischen den aufgebrachten Leiterbahnen herstellen. Das Basismaterial übernimmt dabei die Haftwirkung für die Leiterbahnen.

Es wird deutlich, daß eine Auflösung des anisotrop leitenden Klebers, das heißt der minimal mögliche Abstand zwischen zwei benachbarten elektrisch leitenden Verbindungen, von der Struktur der dispergierten elektrisch leitenden Teilchen abhängt. Damit diese die elektrisch leitende Verbindung in nur einer Richtung ermöglichen, müssen diese einen genügend großen Abstand zueinander aufweisen, damit eine unerwünschte elektrisch leitende Verbindung zwischen den Teilchen untereinander vermieden wird. Es ist jedoch nachteilig, daß es beim Dispergieren der leitfähigen Teilchen in das Basismaterial zu einer Koagulation, das heißt einer Zusammenballung einer Mehrzahl der elektrisch leitenden Teilchen, kommt. Hierdurch können die bekannten anisotrop leitenden Kleber nur zum Kontaktieren relativ weit auseinander angeordneter Leiterbahnen oder ähnlichem verwendet werden, da ansonsten eine ausreichend große Kontaktsicherheit nicht gegeben ist.

### Vorteile der Erfindung

Der erfindungsgemäße anisotrop leitende Kleber mit den im Anspruch 1 genannten Merkmalen hat demgegenüber den Vorteil, daß eine gleichmäßige Dispergierung der leitfähigen Teilchen in dem Basismaterial möglich ist. Dadurch, daß die leitfähigen Teilchen auf ihrer Oberfläche Abstandsmittel aufweisen, wird eine Koagulation der Teilchen vermieden. Diese liegen somit gleichmäßig dispergiert in dem Basismaterial vor, ohne daß die Teilchen untereinander elektrisch leitend verbunden sind. Hierdurch ergibt sich der Vorteil, daß der minimale Abstand zwischen zwei benachbarten Kontaktverbindungen an sich nur noch von einer Körnchengröße der elektrisch leitfähigen Teilchen bestimmt wird. Die Anisotropie der Kontaktverbindung wird dabei mit hoher Sicherheit gewährleistet.

In bevorzugter Ausgestaltung der Erfindung ist vorgesehen, daß die Abstandsmittel eine Beschichtung aus Liganden sind, die vorzugsweise thermisch nicht stabil sind. Hierdurch wird erreicht, daß die elektrisch leitfähigen Teilchen durch die Liganden in einem unverarbeiteten Leitkleber auf Abstand gehalten werden. Dadurch, daß die Liganden thermisch nicht stabil sind, werden diese während des Klebe- und Kontaktierungsprozesses aufgelöst und können somit die Herstellung einer elektrisch leitenden Verbindung nicht behindern. Die Auflösung der Liganden erfolgt erst zu einem Zeitpunkt des Klebe- und Verbindungsprozesses, bei dem die elektrisch leitfähigen Teilchen bereits unter einem bestimmten Druck stehen, so daß diese trotz des Wegfalls der Abstandsmittel nicht mehr miteinander in Kontakt kommen können.

Weitere vorteilhafte Ausgestaltungen der Erfindung ergeben sich aus den übrigen in den Unteransprüchen genannten Merkmalen.

### Zeichnung

Die Erfindung wird nachfolgend in einem Ausführungsbeispiel anhand der zugehörigen Zeichnungen näher eräutert. Es zeigen:
- Figur 1: eine Schnittdarstellung durch einen anisotrop leitenden Kleber im Ausgangszustand und
- Figur 2: eine Schnittdarstellung durch einen anisotrop leitenden Kleber im kontaktierten Zustand.

### Beschreibung des Ausführungsbeispiels

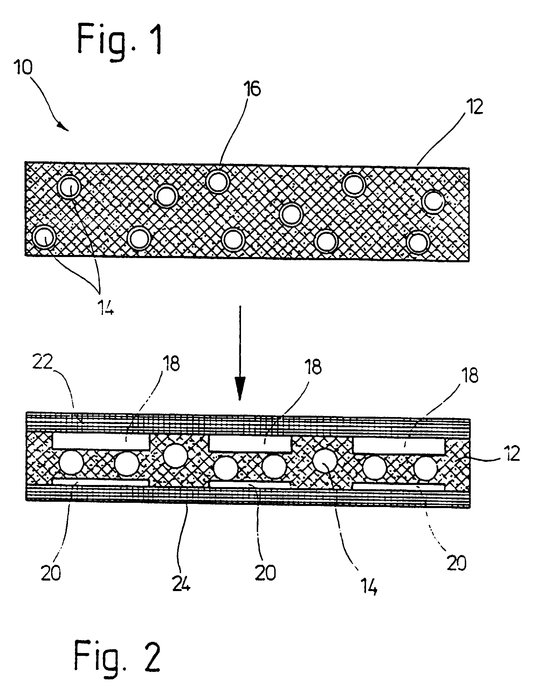

Figur 1 zeigt einen in Folienform vorliegenden anisotrop leitfähigen Kleber 10. Der Kleber 10 besteht aus einem Basismaterial 12 und darin dispergierten, also feinverteilten, leitfähigen Teilchen 14. Das Basismaterial 12 besteht dabei beispielsweise aus einem Duroplast oder einem Thermoplast. Die Teilchen 14 können beispielsweise aus Gold, Nickel, vergoldetem Nickel, Silber oder goldbeschichteten Styroporkugeln bestehen. Die Teilchen 14 sind mit einer Beschichtung 16 versehen, die in der Figur 1 nicht maßstäblich angedeutet ist. Die Beschichtung 16 besteht dabei beispielsweise aus Triphenylphosphin.

Figur 2 zeigt eine Möglichkeit einer geklebten Verbindung mit dem in Figur 1 dargestellten Kleber. Auf den sich gegenüberliegenden Oberflächen des Klebers 10 werden Leiterbahnen 18 und 20 aufgebracht. Die Leiterbahnen 18 bzw. 20 liegen dabei noch auf dem Kleber 10 auf und sind nicht in diesen eingedrungen. Über den Leiterbahnen 18 wird beispielsweise eine Folie 22 aus Polyester oder Polyamid aufgebracht. Die Leiterbahnen 20 werden ebenfalls mit einer Folie 24 abgedeckt. Die Folien 22 und 24 können dabei gleichzeitig Bestandteil eines elektronischen Bauelementes, das die Leiterbahnen 18 oder 20 aufweist.

Eine Kontaktierung mit dem in den Figuren 1 und 2 gezeigten Kleber 10 findet folgendermaßen statt. Auf das aus dem Kleber 10 mit den aufgelegten Leiterbahnen 18 und 20 sowie den Folien 22 und 24 bestehende System wird mit einem Stempel, in Figur 2 durch den Pfeil angedeutet, ein Druck ausgeübt. Gleichzeitig erfolgt eine Erwärmung des Systems. Durch die Erwärmung wird das aus dem Thermoplast bestehende Basismaterial 12 aufgeweicht, so daß die Leiterbahnen 18 und 20 unter dem Druck des Stempels in das Basismaterial 12 eindringen können. Während des Erwärmens zersetzt sich die Beschichtung 16 aus Triphenylphosphin, da diese eine Zersetzungstemperatur von ca. 60 °C aufweist, während das Basismaterial 12 auf eine Temperatur von ca. 150 bis 230 °C erwärmt wird. Durch die Zersetzung der Beschichtung 16 können die Leiterbahnen 18 und 20 so weit an die Teilchen 14 herangepreßt werden, daß zwischen den Teilchen 14 und den Leiterbahnen 18 bzw. 20 eine elektrisch leitende Verbindung entsteht. Nachdem das System ausgehärtet ist, beispielsweise in einer Zeit von 5 bis 30 Sekunden, kann der Stempel entfernt werden, und die Leiterbahnen 18 und 20 sind dauernd elektrisch miteinander kontaktiert. Dadurch, daß die elektrische Verbindung ausschließlich von zwischen den Leiterbahnen 18 und 20 sich befindenden Teilchen 14 übenommen wird, können nebeneinanderliegende Kontaktierungen zwischen Leiterbahnen 18 und 20 auf engstem Raum realisiert werden, ohne daß es zu Fehlverbindungen über sich berührende Teilchen 14 kommt. Insgesamt ist dadurch eine höhere Auflösung zwischen nebeneinanderliegenden Leiterbahnen 18 und 20 möglich. Die Kontaktverbindung insgesamt wird dadurch sehr sicher. Sehr vorteilhaft lassen sich mit dem in den Figuren 1 und 2 gezeigten anisotrop leitenden Kleber 10 flexible Verbindungen zwischen den Leiterbahnen 18 und 20 herstellen. Die Flexibilität der Verbindung hängt dabei lediglich von dem Basismaterial 12 ab.

Die Erfindung beschränkt sich nicht auf das in den Figuren 1 und 2 gezeigte Ausführungsbeispiel. Der Kleber 10 kann beispielsweise auch als Paste, Film oder Heißsiegelfolie ausgebildet sein. Das Verbinden von zwei Leiterbahnen 18 und 20 ist lediglich auch als die einfachste Ausführungsform zu verstehen. Über entsprechend strukturierte Stempel können beispielsweise über die Oberfläche eines Klebers 10 verteilte verschiedene Durchkontaktierungen hergestellt werden, die je nach Anwendungsfall variabel sind.

## Patentansprüche

1. Anisotrop leitender Kleber mit in einem Basismaterial dispergierten leitfähigen Teilchen, dadurch gekennzeichnet, daß die Teilchen (14) auf ihrer Oberfläche als Abstandsmittel Liganden aufweisen, die sich während eines Klebeprozesses zersetzen.

2. Kleber nach Anspruch 1, dadurch gekennzeichnet, daß die Liganden thermisch nicht stabil sind.

3. Kleber nach einem der vorhergehenden Ansprüche, dadurch gekennzeichnet, daß die Liganden eine zersetzungstemperatur besitzen, die unterhalb einer Verklebetemperatur liegt.

4. Kleber nach einem der vorhergehenden Ansprüche, dadurch gekennzeichnet, daß als Ligand Triphenylphosphin verwendet wird.

5. Kleber nach einem der vorhergehenden Ansprüche, dadurch gekennzeichnet, daß als Ligand Propionsäure verwendet wird.

6. Kleber nach einem der vorhergehenden Ansprüche, dadurch gekennzeichnet, daß die Teilchen (14) aus Gold, Nickel, vergoldetem Nickel, Silber oder goldbeschichteten Styroporkugeln bestehen.

7. Kleber nach einem der vorhergehenden Ansprüche, dadurch gekennzeichnet, daß das Basismaterial aus einem Duroplast oder einem Thermoplast besteht.

8. Verfahren zur Herstellung einer geklebten, elektrisch leitfähigen Verbindung zwischen Leiterbahnen, dadurch gekennzeichnet, daß die Leiterbahnen auf sich gegenüberliegenden Oberflächen eines Klebers nach einem der Patentansprüche 1 bis 7 aufgebracht werden, auf den Kleber und die Leiterbahnen Druck ausgeübt wird und die im Kleber enthaltenen Liganden zersetzt werden.

9. Verfahren nach Anspruch 8, dadurch gekennzeichnet, daß die Liganden unter Erwärmung zersetzt werden.

## Claims

1. Anisotropically conducting adhesive with conductive particles dispersed in a base material, characterized in that the particles (14) have ligands as spacers on their surface, these ligands breaking down in the course of a bonding process.

2. Adhesive according to Claim 1, characterized in that the ligands are thermally unstable.

3. Adhesive according to one of the preceding claims, characterized in that the ligands have a decomposition temperature which is below a bonding temperature.

4. Adhesive according to one of the preceding claims, characterized in that triphenylphosphine is used as ligand.

5. Adhesive according to one of the preceding claims, characterized in that propionic acid is used as ligand.

6. Adhesive according to one of the preceding claims, characterized in that the particles (14) consist of gold, nickel, gold-coated nickel, silver, or gold-coated Styropor beads.

7. Adhesive according to one of the preceding claims, characterized in that the base material consists of a thermoset or of a thermoplastic.

8. Process for producing a bonded, electrically conductive connection between conductor tracks, characterized in that the conductor tracks are applied to opposing surfaces of an adhesive according to one of Claims 1 to 7, pressure is exerted on the adhesive and the conductor tracks, and the ligands present in the adhesive are caused to undergo decomposition.

9. Process according to Claim 8, characterized in that the ligands are caused to undergo decomposition by heating.

## Revendications

1. Adhésif à conductibilité anisotrope avec des particules conductrices dispersées dans une matière de base,
caractérisé en ce que
les particules (14) présentent sur leurs surfaces des coordinats, en tant que moyens d'écartement, qui se décomposent pendant un processus de collage.

2. Adhésif selon la revendication 1,
caractérisé en ce que
les coordinats ne sont pas stables thermiquement.

3. Adhésif selon l'une des revendications précédentes,
caractérisé en ce que
les coordinats possèdent une température de décomposition qui se trouve en dessous d'une température de collage.

4. Adhésif selon l'une des revendications précédentes,
caractérisé en ce que
l'on utilise comme coordinat du triphénylphosphine.

5. Adhésif selon l'une des revendications précédentes,
caractérisé en ce que
l'on utilise comme coordinat de l'acide propionique.

6. Adhésif selon l'une des revendications précédentes,
caractérisé en ce que
les particules (14) sont en or, en nickel, en nickel doré, en argent ou en billes styroporeuses enduites d'or.

7. Adhésif selon l'une des revendications précédentes,
caractérisé en ce que
la matière de base est faite d'une résine durcissable ou d'une résine thermoplastique.

8. Procédé de fabrication d'une liaison adhésive, électriquement conductrice, entre des pistes conductrices,
caractérisé en ce que
les pistes conductrices sont mises sur des surfaces se faisant vis à vis d'un adhésif selon l'une des revendications 1 à 7,
une pression est exercée sur l'adhésif et sur les pistes conductrices et
les coordinats contenus dans l'adhésif sont décomposés.

9. Procédé selon la revendication 8,
caractérisé en ce que
les coordinats sont décomposés par échauffement.
